# EUROPÄISCHE PATENTSCHRIFT

(11) **EP 0 925 512 B1**
(45) Veröffentlichungstag und Bekanntmachung des Hinweises auf die Patenterteilung: **31.03.2004**
(21) Anmeldenummer: 98936239.7
(22) Anmeldetag: 19.06.1998
(51) Int. Cl.: G01R 31/28

(54) **VERFAHREN UND SCHALTUNG ZUR FUNKTIONSÜBERWACHUNG EINER SENSORBRÜCKE**
METHOD AND CIRCUIT FOR MONITORING THE FUNCTIONING OF A SENSOR BRIDGE
PROCEDE ET CIRCUIT POUR LA SURVEILLANCE DU FONCTIONNEMENT DE CAPTEURS EN PONT

(30) Priorität: 03.07.1997 DE 19728381
(43) Veröffentlichungstag der Anmeldung: 30.06.1999
(73) Patentinhaber: ROBERT BOSCH GMBH, 70442 Stuttgart (DE)
(72) Erfinder: PFAFF, Georg, D-71706 Markgroeningen (DE); KELLER, Herbert, D-75446 Wiernsheim (DE)
(86) Internationale Anmeldenummer: PCT/DE1998/001698
(87) Internationale Veröffentlichungsnummer: WO 1999/001777

(56) Entgegenhaltungen:
- EP-A- 0 723 161
- DE-A- 19 539 458

## Beschreibung

Diese Erfindung betrifft ein Verfahren und eine Schaltungsanordnung zur Funktionsüberwachung einer symmetrischen Sensorbrückenschaltung, die in Vollbrückenschaltung verbundene Sensorelemente aufweist. Zur Erfassung einer physikalischen Größe, wie z.B. Druck, Geschwindigkeit, Beschleunigung oder dergleichen, dient häufig ein im Stand der Technik bekannter in Form einer symmetrischen Brückenschaltung angeordneter Halbleitersensor und eine Differenzverstärkerschaltung, die ein Ausgangssignal der Sensorbrückenschaltung erzeugt. Dieses Ausgangssignal von der Sensorbrückenschaltung gibt innerhalb eines bestimmten Meßspannungsbereichs die zu messende physikalische Größe, z.B. den Druck, in weitgehend linearer Abhängigkeit an.

Beim Einsatz einer solchen Sensorbrückenschaltung in einer sicherheitsrelevanten Meßanordnung, wie z.B. in einem Antiblockiersystem eines Kraftfahrzeugs, ist es für die Sicherheit des Kraftfahrzeugs und seiner Insassen sehr wichtig, daß die Funktion des Sensors während seines Betriebs ständig überwacht wird und daß bei Fehlfunktion des Sensors unverzüglich ein diese Fehlfunktion anzeigendes Alarmsignal erzeugt werden kann. Auch ist es dabei wichtig, daß nicht nur Unterbrechungen der Leitungen zu und von der Sensorbrückenschaltung, der Speiseleitungen u.ä., sondern auch einen Ausfall des Drucksensors herbeiführende Fehlerzustände erfaßt werden können, so daß auch allmählich auftretende Veränderungen, wie z.B. Veränderungen der Kennlinie des Drucksensors, der Verstärkungsgrade der integrierten Verstärker etc., erkannt werden können, die allmählich die Meßgenauigkeit verschlechtern.

Eine bekannte, in der US 4 845 435 beschriebene Sensorfehler-Detektoreinrichtung zum Erfassung einer Leitungsunterbrechung oder eines Kurzschlusses weist zwischen einem masseseitigen Ausgangsanschluß eines Sensors und dem Sensor einen Widerstand zur Bildung eines Sensorausgangssignals auf. Ein Vergleich des so gebildeten Sensorausgangssignals mit einer Bezugsspannung erlaubt anhand des Ausgangszustands eines hierzu eingesetzten Vergleichers einen Rückschluß auf den Zustand oder die Funktionsfähigkeit des Sensors. Wenn beispielsweise ein Sensor mit einem A/D-Wandler geschaltet wird, ist die Zuverlässigkeit der bekannten Anordnung bei der Erkennung von Unterbrechungen der jeweiligen Spannungsversorgungsanschlüsse, der Ausgangsanschlüsse und der Masseanschlüsse der Sensoren nicht sicher.

### Darstellung der Erfindung

Aufgabe der Erfindung ist es, ein Verfahren und eine Schaltungsanordnung zur Funktionsüberwachung einer in Vollbrückenschaltung verbundene Sensorelemente aufweisenden symmetrischen Sensorbrückenschaltung so zu ermöglichen, daß das Sensorsignal während aller Betriebszustände ohne Auftrennen der Meßsignalkette und, bei geringem Kostenaufwand, nicht nur die Sensorzuleitungen, die Speisespannungsleitungen, die Bondverbindungen, sondern auch die Brückenwiderstände, die gesamten Verstärker und die Abgleich- und Kompensationsbausteine der Meßsignalkette selbsttätig überwacht werden können.

Ein die obige Aufgabe lösendes erfindungsgemäßes Verfahren zur Funktionsüberwachung einer symmetrischen Sensorbrückenschaltung ist gekennzeichnet durch folgende Schritte:
- Ableitung eines Vollbrückensignals von der Sensorbrückenschaltung;
- Ableitung eines Halbbrückensignals von der positiven oder negativen Halbbrückenschaltung;
- Subtraktion des momentanen Pegels dieses Halbbrückensignals von der halben Brückenspeisespannung unter Bildung eines Differenzsignals;
- Verstärkung des Differenzsignals mit einem bestimmten Verstärkungsfaktor, so daß es bei korrekter Funktion der Sensorbrückenschaltung dem Vollbrückensignal entspricht;
- Vergleich des Vollbrückensignals mit dem verstärkten Differenzsignal; und
- Erzeugung eines Alarmsignals, wenn das verstärkte Differenzsignal unzulässig vom Vollbrückensignal abweicht.

Dieses Verfahren wird erfindungsgemäß und vorteilhaft dadurch weitergebildet, daß das Vollbrückensignal verstärkt und daraus das Ausgangssignal des Sensors gebildet und das Alarmsignal mit festem Pegel, fester Frequenz, o.ä. erzeugt und dem Ausgangssignal des Sensors überlagert wird.

Vorteilhafterweise ist der Pegel des Alarmsignals so gewählt, daß das Ausgangssignal des Sensors im Alarmfall außerhalb des normalen Arbeitsbereich des Sensors zu liegen kommt.

Weiterhin wird bevorzugt das verstärkte Differenzsignal und das Vollbrückensignal vor dem Vergleichsschritt einer Aufbereitung im Offset und der Empfindlichkeit im gleichen Maß und gleichzeitig unterworfen.

Bevorzugt wird das erfindungsgemäße Verfahren für die Funktionsüberwachung eines Drucksensors verwendet, der bei der Druckmessung in einem Antiblockiersystem eines Kraftfahrzeugs eingesetzt ist.

Weiterhin kann das erfindungsgemäße Verfahren für die Funktionsüberwachung eines in Diesel- oder Benzineinspritzsystemen oder zur Druckmessung in einem Lenk- oder Schaltgetriebe oder in einer Klimaanlage eines Kraftfahrzeugs eingesetzten Drucksensors verwendet werden.

Gemäß einem weiteren Aspekt der Erfindung wird die obige Aufgabe gelöst durch eine Schaltungsanordnung zur Funktionsüberwachung einer symmetrischen Sensorbrückenschaltung, wobei die Schaltungsanordnung erfindungsgemäß gekennzeichnet ist durch
- einen mit Meßanschlüssen der Sensorbrückenschaltung verbundenen Differenzverstärker zur Bildung eines das Meßsignal darstellenden Vollbrückensignals aus der Differenz des positiven und negativen Halbbrückensignals;
- ein mit dem positiven oder negativen Meßanschluß der Sensorbrückenschaltung verbundenes Summierglied zur Subtraktion des momentanen Pegels des positiven oder negativen Halbbrückensignals von der Hälfte der Brückenspeisespannung und Erzeugung eines entsprechenden Differenzsignals;
- ein mit dem Summierglied verbundenes Verstärkungsglied zur Verstärkung des Differenzsignals mit einem bestimmten Verstärkungsfaktor, so daß das Differenzsignal bei korrekter Funktion der Sensorbrückenschaltung dem Vollbrückensignal entspricht;
- einen Vergleicher, der mit dem Verstärkungsglied zum Vergleich des Vollbrückensignals mit dem verstärkten Differenzsignal verbunden ist, und
- einen Alarmsignalerzeuger, der vom Ausgangssignal des Vergleichers zur Erzeugung eines Alarmsignals aktiviert wird, wenn das vom Verstärkungsglied verstärkte Differenzsignal unzulässig vom Vollbrückensignal abweicht.

Bevorzugt weist der Vergleicher einen Fensterkomparator auf, dessen Ausgangssignal das Alarmsignal ist und das als zusätzliche Spannung einem von einem zweiten Verstärkungsglied verstärkten Ausgangssignal des Sensors überlagert wird, so daß letzteres im Fehlerfall des Sensors einen Signalbereich außerhalb des normalen Arbeitsbereichs des Sensors einnimmt.

Optionell und bevorzugt ist eine offset- und Empfindlichkeitskorrekturvorrichtung vorgesehen, die das vom Verstärkungsglied verstärkte Differenzsignal und das Vollbrückensignal, bevor diese im Vergleicher verglichen werden, einer Aufbereitung im Offset und in der Empfindlichkeit im gleichen Maß und gleichzeitig unterwirft.

Weiterhin kann erfindungsgemäß dem Ausgangssignal des Sensors durch einen Sockelspannungserzeuger eine Sockelspannung überlagert werden, die das Ausgangssignal des Sensors in den Arbeitsbereich desselben bringt.

Weiterhin können bevorzugt Mittel vorgesehen sein, mit denen zuvor die Verstärkungsgrade der Verstärkungsglieder, die den normalen Arbeitsbereich und den Alarmsignalbereich definierenden Bezugsspannungen des Vergleichers und des Sockelspannungserzeugers entsprechend der Speisespannung und den Kennwerten der eingesetzten Sensorvollbrückenschaltung eingestellt werden können.

Durch die oben angegebenen Lösungsmerkmale wird durch den Vergleich des Halbbrückensignals mit dem Vollbrückensignal ein zweiter Signalmeßpfad aufgebaut. Dieser wird im Sensor mit dem Hauptmeßkanal verglichen. Dadurch entsteht ein Sensor im Sensor, wobei der Test- oder Überwachungskanal ausschließlich zur Überprüfung des Hauptmeßkanals verwendet wird.

Das erfindungsgemäße Verfahren und die Schaltungsanordnung ermöglichen somit eine selbsttätige Funktionsüberwachung der Sensorbrückenschaltung während des Betriebs und zwar im druckbeaufschlagten oder drucklosen Zustand des Sensors.

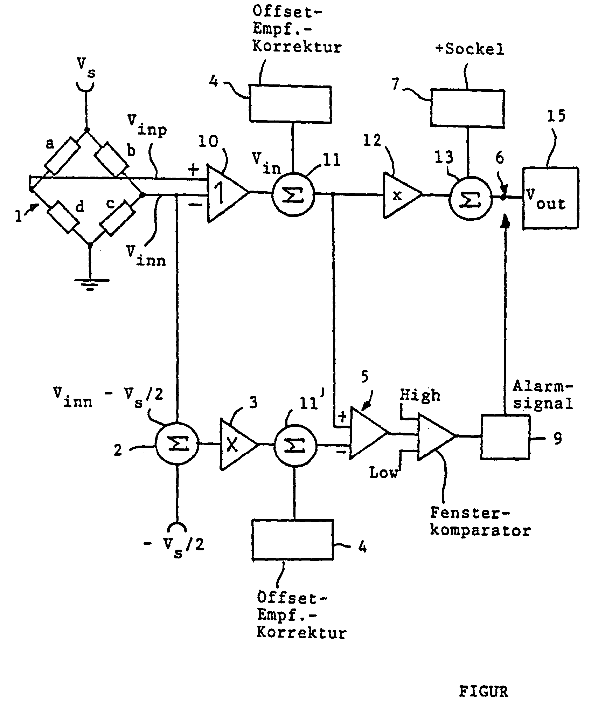

Weitere vorteilhafte Merkmale und Aufgaben der Erfindung werden anhand der nachfolgenden Beschreibung eines Ausführungsbeispiels deutlich, wenn diese unter Bezug auf die einzige Zeichnungsfigur gelesen wird.

Die Zeichnungsfigur zeigt in Form eines Funktionsblockschaltbildes ein bevorzugtes Ausführungsbeispiel einer Schaltungsanordnung für die Funktionsüberwachung einer symmetrischen Sensorbrückenschaltung, insbesondere für die Druckmessung in einer Antiblockiersystem-Bremsanlage.

Das in der Figur dargestellte Blockschaltbild des Ausführungsbeispiels der erfindungsgemäßen Überwachungsschaltung zeigt einen Meßsensor, z.B. einen Drucksensor 1, bei dem vier gleichartige Sensorelemente a, b, c, d in Form einer symmetrischen Vollbrückenschaltung verbunden sind. Der Speisespannungsanschluß dieser Vollbrückenschaltung liegt an einer Speisespannung Vₛ und andererseits an Masse. Ein positives Ausgangssignal Vᵢₙₚ und ein negatives Ausgangssignal Vᵢₙₙ der symmetrischen Vollbrückenschaltung 1 liegen jeweils einem positiven und negativen Eingangsanschluß eines Differenzverstärkers an, von dessen Ausgang ein Vollbrückensignal Vᵢₙ abgegeben wird. Ein Hauptmeßkanal I führt dieses Vollbrückensignal Vᵢₙ über einen Summierknoten 11, dessen Funktion später erläutert wird, zu einem Verstärker (zweites Verstärkungsglied) 12 mit fest eingestelltem Verstärkungsgrad. Weiter führt der Hauptmeßkanal I über einen weiteren Summierknoten 13 zu einem Ausgangsanschluß 15, an dem eine Sensorausgangsspannung 6 (Vₒᵤₜ) abgegeben wird.

Weiterhin wird ein Test- oder Überwachungssignalkanal II dadurch gebildet, daß durch einen weiteren Summierknoten 2 die Hälfte der Brückenspeisespannung Vₛ/2 von dem negativen Halbbrückensignal Vᵢₙₙ subtrahiert und anschließend in einem Verstärker 3 verstärkt wird, dessen Verstärkungsgrad so eingestellt ist, daß das verstärkte Differenzsignal Vᵢₙₙ-Vₛ/2 dem Vollbrückensignal Vin entspricht. Diese verstärkte Differenzsignal wird über einen weiteren Summierknoten 11' einem Vergleicher 5 zugeführt, der einen Differenzverstärker in Verbindung mit einem Fensterkomparator aufweist. Im Vergleicher 5 wird das verstärkte Differenzsignal mit dem unverstärkten Vollbrückensignal Vᵢₙ verglichen. Weicht nun das verstärkte Differenzsignal unzulässig vom Vollbrückensignal ab, aktiviert das Ausgangssignal vom Fensterkomparator einen Alarmsignalerzeuger 9, der dem Ausgangssignal Vₒᵤₜ am Ausgangsanschluß 15 des Sensors eine zusätzliche Spannung aufschaltet, welche das Ausgangssignal des Sensors in einen Signalbereich bringt, der außerhalb des normalen Arbeitsbereich des Sensors liegt.

Durch die zuvor erwähnten Maßnahmen wird ein Sensor im Sensor ermöglicht, wobei der Test- und Überwachungskanal II ausschließlich zur Funktionsüberprüfung des Hauptmeßkanals I verwendet wird. Der Sensor überwacht sich während des Betriebs im druckbeaufschlagten oder drucklosen des Drucksensors 1 selbsttätig in seiner Funktion.

Eine Offset- und Empfindlichkeitskorrekturvorrichtung 4 dient dazu, wenn erforderlich, das Vollbrückensignal Vᵢₙ und das verstärkte Differenzsignal Vᵢₙₙ-Vₛ/2 einer offset- und Empfindlichkeitskorrektur zu unterwerfen (z.B. Temperaturfehlerkompensation), damit diese beiden Signale im Offset und in der Empfindlichkeit ein gleiches Signal ausweisen. Dazu werden die beiden Signale Vᵢₙ und Vᵢₙₙ-Vₛ/2 mit einer Korrekturspannung in den beiden im Hauptmeßkanal I und im Test- und Überwachungskanal II liegenden Summierknoten 11, 11' beaufschlagt.

Durch einen weiteren im Hauptmeßkanal I enthaltenen Summierknoten 13 wird dem Meßsignal eine konstante Spannung, z.B. 0,5 V von einem Sockelspannungserzeuger 7 aufgeschaltet, so daß das Ausgangssignal Vₒᵤₜ in den Arbeitsbereich des Sensors gebracht wird.

Die in der Figur gezeigten Bauteile und Schaltelemente sind bevorzugt auf einem gemeinsamen Substrat in Form einer integrierten Schaltung integriert. Die für die Funktionsüberwachung der Sensorbrückenschaltung benötigten Bauelemente vergrößern die Chip-Fläche der integrierten Schaltung nur geringfügig, so daß der dabei entstehende Kostenmehraufwand vernachlässigbar ist.

Selbstverständlich kann statt des negativen Halbbrückensignals Vᵢₙₙ, wie in der Figur gezeigt, auch das positive Halbbrückensignal Vᵢₙₚ von der Sensorhalbbrücke abgegriffen und die Differenz zur Hälfte der Speisespannung gebildet werden.

Insgesamt ermöglicht das erfindungsgemäße Meßprinzip die Überwachung des von einer symmetrischen Vollbrückenschaltung gelieferten Meßsignals während aller Betriebszustände, indem ohne Auftrennung der Meßsignalkette ein Überwachungssignal vom Brückensignal abgenommen und mit dem Vollbrückensignal verglichen wird, so daß das Meßsignal kontinuierlich zur Verfügung steht. Dadurch werden nicht nur die Zu- und Ableitungen von der Meßbrücke sowie die Spannungsversorgungsleitungen auf Bruch und Kurzschlüsse sondern auch die Brückenwiderstände und die gesamten Verstärker sowie die Abgleich- und Kompensationsbausteine selbsttätig überwacht.

## Patentansprüche

1. Verfahren zur Funktionsüberwachung einer symmetrischen Sensorbrückenschaltung (1), die in Vollbrückenschaltung verbundene Sensorelemente (a, b, c, d) aufweist,
**gekennzeichnet durch**
folgende Schritte:
- Ableitung eines Vollbrückensignals (Vᵢₙ) von der Sensorbrückenschaltung;
- Ableitung eines Halbbrückensignals (Vᵢₙₚ;Vᵢₙₙ) von der positiven oder negativen Halbbrückenschaltung;
- Subtraktion des momentanen Pegels dieses Halbbrückensignals (Vᵢₙₚ;Vᵢₙₙ) von der halben Brückenspeisespannung (Vₛ/2) unter Bildung eines Differenzsignals (Vᵢₙₙ-Vₛ/2);
- Verstärkung des Differenzsignals mit einem bestimmten Verstärkungsfaktor (x), so daß es bei korrekter Funktion der Sensorbrückenschaltung (1) dem Vollbrückensignal (Vᵢₙ) entspricht;
- Vergleich des Vollbrückensignals (Vᵢₙ) mit dem verstärkten Differenzsignal; und
- Erzeugung eines Alarmsignals, wenn das verstärkte Differenzsignal unzulässig vom Vollbrückensignal (Vᵢₙ) abweicht.

2. Verfahren nach Anspruch 1,
**dadurch gekennzeichnet, daß**
das Vollbrückensignal (Vᵢₙ) verstärkt und daraus das Ausgangssignal (Vₒᵤₜ) des Sensors gebildet und das Alarmsignal mit festem Pegel, fester Frequenz, o.ä. erzeugt und dem Ausgangssignal (Vₒᵤₜ) des Sensors überlagert wird.

3. Verfahren nach Anspruch 2,
**dadurch gekennzeichnet, daß**
der Pegel des Alarmsignals so gewählt ist, daß das Ausgangssignal des Sensors im Alarmfall außerhalb des normalen Arbeitsbereichs des Sensors zu liegen kommt.

4. Verfahren nach einem der vorangehenden Ansprüche,
**dadurch gekennzeichnet, daß**
weiterhin das verstärkte Differenzsignal und das Vollbrückensignal (Vᵢₙ) im Offset und in der Empfindlichkeit im gleichen Maß und gleichzeitig vor dem Vergleichsschritt aufbereitet werden.

5. Verwendung des Verfahrens nach einem der Ansprüche 1 bis 4 zur Funktionsüberwachung eines Drucksensors, der bei der Druckmessung in einem Antiblockiersystem oder bei Diesel- oder Benzin-Einspritzverfahren oder zur Druckmessung in Lenkgetrieben, Klimaanlagen oder Schaltgetrieben eines Kraftfahrzeugs eingesetzt ist.

6. Schaltungsanordnung zur Funktionsüberwachung einer symmetrischen Sensorbrückenschaltung (1), die in Vollbrückenschaltung verbundene, von einer Brückenspeisespannung (Vₛ) gespeiste Sensorelemente (a, b, c, d) aufweist,
**gekennzeichnet durch**
- einen mit Meßanschlüssen der Sensorbrückenschaltung verbundenen Differenzverstärker (10) zur Bildung eines das Meßsignal darstellenden Vollbrückensignals (Vᵢₙ) aus der Differenz des positiven und negativen Halbbrückensignals (Vᵢₙₚ-Vᵢₙₙ);
- ein mit dem positiven oder negativen Meßanschluß der Sensorbrückenschaltung (1) verbundenes Summierglied (2) zur Subtraktion des momentanen Pegels des positiven oder negativen Halbbrückensignals (Vᵢₙₚ oder Vᵢₙₙ) von der Hälfte der Brückenspeisespannung (Vₛ/2) und Erzeugung eines entsprechenden Differenzsignals (Vᵢₙₙ-Vₛ/2);
- ein mit dem Summierglied (2) verbundenes Verstärkungsglied (3) zur Verstärkung des Differenzsignals mit einem bestimmten Verstärkungsfaktor (x), so daß das Differenzsignal bei korrekter Funktion der Sensorbrückenschaltung dem Vollbrückensignal (Vᵢₙ) entspricht;
- einen Vergleicher (5), der mit dem Verstärkungsglied (3) zum Vergleich des Vollbrückensignals (Vᵢₙ) mit dem verstärkten Differenzsignal verbunden ist, und
- einen Alarmsignalerzeuger (9), der vom Ausgangssignal des Vergleichers (5) zur Erzeugung eines Alarmsignals aktiviert wird, wenn das vom Verstärkungsglied (3) verstärkte Differenzsignal unzulässig vom Vollbrückensignal (Vᵢₙ) abweicht.

7. Schaltungsanordnung nach Anspruch 6,
**dadurch gekennzeichnet, daß**
der Vergleicher (5) einen Fensterkomparator aufweist, dessen Ausgangssignal das Alarmsignal ist und als zusätzliche Spannung einem von einem zweiten Verstärkungsglied (12) verstärkten Ausgangssignal (6) des Sensors überlagert wird, so daß dieses Ausgangssignal im Fehlerfall des Sensors einen Signalbereich außerhalb des normalen Arbeitsbereichs des Sensors einnimmt.

8. Schaltungsanordnung nach Anspruch 6 oder 7,
**dadurch gekennzeichnet, daß**
weiterhin eine Offset- und Empfindlichkeitskorrekturvorrichtung (4) vorgesehen ist, die das vom ersten Verstärkungsglied (3) verstärkte Differenzsignal sowie das Vollbrückensignal (Vᵢₙ) einer Offset- und Empfindlichkeitsaufbereitung in gleichem Maß und gleichzeitig vor ihrem Vergleich im Vergleicher (5) unterwirft.

9. Schaltungsanordnung nach einem der Ansprüche 6 bis 8,
**dadurch gekennzeichnet, daß**
weiterhin durch einen Sockelspannungserzeuger (7) dem Ausgangssignal des Sensors eine Sockelspannung (+_{Sockel}) überlagert wird, die dieses Ausgangssignal in den Arbeitsbereich des Sensors bringt.

10. Schaltungsanordnung nach einem der Ansprüche 6 bis 9,
**dadurch gekennzeichnet, daß**
außerdem Mittel vorgesehen sind, mit denen zuvor die Verstärkungsgrade jeweils des ersten und zweiten Verstärkungsglieds (3, 12), die den normalen Arbeitsbereich und den Alarmsignalbereich definierende Bezugsspannungen des Vergleichers und des Sockelspannungserzeugers (7) entsprechend der Speisespannung und den Kennwerten der eingesetzten Sensor-Vollbrückenschaltung (1) eingestellt werden.

11. Verwendung der Schaltungsanordnung nach einem der Ansprüche 6 bis 10 **dadurch gekennzeichnet daß** diese in der Funktionsüberwachung eines für die Druckmessung in einem Antiblockiersystem eines Kraftfahrzeugs eingesetzten Drucksensors verwendet ist.

12. Verwendung der Schaltungsanordnung nach einem der Ansprüche 6 bis 10 **dadurch gekennzeichnet daß** diese in der Funktionsüberwachung eines für die Druckmessung bei der Diesel-Einspritzung oder Benzin-Einspritzung, in einem Lenkgetriebe, einer Klimaanlage oder in einem Automatikschaltgetriebe eingesetzten Drucksensors verwendet ist.

## Claims

1. Method for monitoring the function of a symmetrical sensor bridge circuit (1) which has sensor elements (a, b, c, d) connected in a full bridge circuit, **characterized by** the following steps:
- a full bridge signal (Vᵢₙ) is derived from the sensor bridge circuit;
- a half bridge signal (Vᵢₙₚ; Vᵢₙₙ) is derived from the positive or negative half bridge circuit;
- the instantaneous level of this half bridge signal (Vᵢₙₚ; Vᵢₙₙ) is subtracted from the half bridge feed voltage (Vₛ/2) forming a difference signal (Vᵢₙₙ-Vₛ/2);
- the difference signal is amplified with a specific gain factor (x) so that it corresponds to the full bridge signal (Vᵢₙ) when the sensor bridge circuit (1) is functioning correctly;
- the full bridge signal (Vᵢₙ) is compared with the amplified difference signal; and
- an alarm signal is generated if the amplified difference signal deviates unacceptably from the full bridge signal (Vᵢₙ).

2. Method according to Claim 1, **characterized in that** the full bridge signal (Vᵢₙ) is amplified and the output signal (Vₒᵤₜ) of the sensor is formed therefrom and the alarm signal is generated with a fixed level, fixed frequency or the like, and superimposed on the output signal (Vₒᵤₜ) of the sensor.

3. Method according to Claim 2, **characterized in that** the level of the alarm signal is selected such that in the case of an alarm the output signal of the sensor comes to lie outside the normal working range of the sensor.

4. Method according to one of the preceding claims, **characterized in that** the amplified difference signal and the full bridge signal (Vᵢₙ) continue to be conditioned simultaneously before the comparison step, to the same degree in terms of offset and sensitivity.

5. Use of the method according to one of Claims 1 to 4 for functionally monitoring a pressure sensor which is used for measuring the pressure in an anti-lock brake system or in diesel or petrol injection methods or for measuring the pressure in steering gear systems, air-conditioning systems or change-speed gearboxes of a motor vehicle.

6. Arrangement for monitoring the functioning of a symmetrical bridge circuit (1) which has sensor elements (a, b, c, d) which are connected in a full bridge circuit and are fed with a bridge feed voltage (Vₛ), **characterized by**
- a differential amplifier (10) connected to measurement connections of the sensor bridge circuit, for forming a full bridge signal (Vᵢₙ) - which constitutes the measurement signal - from the difference between the positive and negative half bridge signal (Vᵢₙₚ-Vᵢₙₙ);
- a summing element (2), connected to the positive or negative measurement connection of the sensor bridge circuit (1), for subtracting the instantaneous level of the positive or negative half bridge signal (Vᵢₙₚ or Vᵢₙₙ) from the half of the bridge feed voltage (Vₛ/2) and generating a corresponding difference signal (Vᵢₙₙ-Vₛ/2);
- an amplifier element (3) which is connected to the summing element (2), for amplifying the difference signal with a specific gain factor (x) so that when the sensor bridge circuit is functioning correctly the difference signal corresponds to the full bridge signal (Vᵢₙ) ;
- a comparator (5) which is connected to the amplifier element (3) in order to compare the full bridge circuit (Vᵢₙ) with the amplified difference signal, and
- an alarm signal generator (9) which is actuated by the output signal of the comparator (5) in order to generate an alarm signal if the difference signal which is amplified by the amplifier element (3) deviates unacceptably from the full bridge signal (Vᵢₙ).

7. Circuit arrangement according to Claim 6, **characterized in that** the comparator (5) has a window comparator whose output signal is the alarm signal and which is superimposed, as an additional voltage, on an output signal (6), amplified by a second amplifier element (12) of the sensor so that in the case of a fault in the sensor, this output signal assumes a signal range within the normal working range of the sensor.

8. Circuit arrangement according to Claim 6 or 7, **characterized in that** an offset and sensitivity correction device (4) is provided which subjects the difference signal, amplified by the first amplifier element (3), and the full bridge signal (Vᵢₙ) to the same degree of offset and sensitivity conditioning, simultaneously before their comparison in the comparator (5).

9. Circuit arrangement according to one of Claims 6 to 8, **characterized in that**, furthermore, a base voltage (+_{base}) is superimposed on the output signal of the sensor by a base voltage generator (7), said base voltage (+_{base}) displacing this output signal into the working range of the sensor.

10. Circuit arrangement according to one of Claims 6 to 9, **characterized in that** means are also provided with which the degrees of gain of the respective first and second amplifier element (3, 12), the reference voltages of the comparator and of the base voltage generator (7) which define the normal working range and the alarm signal range are set in accordance with the feed voltage and the characteristic values of the sensor full bridge circuit (1) used.

11. Use of the circuit arrangement according to one of Claims 6 to 10, **characterized in that** said circuit arrangement is used in the functional monitoring of a pressure sensor which is used for measuring the pressure in an anti-lock brake system of a motor vehicle.

12. Use of the circuit arrangement according to one of Claims 6 to 10, **characterized in that** said circuit arrangement is used in the functional monitoring of a pressure sensor which is used for measuring the pressure during diesel injection or petrol injection, in a steering gear system, an air-conditioning system or in an automatic change-speed gearbox.

## Revendications

1. Procédé pour la surveillance du fonctionnement d'un circuit de capteurs à pont symétrique (1), qui présente dans le circuit à pont complet des éléments de capteur (a, b, c, d) reliés les uns aux autres,
**caractérisé par**
les étapes suivantes :
- la dérivation d'un signal de pont complet (Vᵢₙ) à partir du circuit de capteurs à pont ;
- la dérivation d'un signal de demi-pont (Vᵢₙₚ ; Vᵢₙₙ) à partir du demi-circuit à pont positif ou négatif ;
- la soustraction du niveau momentané de ce signal de demi-pont (Vᵢₙₚ ; Vᵢₙₙ) de la moitié de la tension d'alimentation de pont (Vₛ/2), afin de permettre la formation d'un signal de différence (Vᵢₙₙ-Vₛ/2) ;
- l'amplification du signal de différence à l'aide d'un coefficient d'amplification donné (x), de telle sorte qu'il corresponde, lors d'un fonctionnement correct du circuit de capteurs à pont (1), au signal de pont complet (Vᵢₙ) ;
- la comparaison du signal de pont complet (Vᵢₙ) avec le signal de différence amplifié ; et
- la génération d'un signal d'alarme lorsque le signal de différence amplifié est trop différent du signal de pont complet (Vᵢₙ).

2. Procédé selon la revendication 1,
**caractérisé en ce que**
le signal de pont complet (Vᵢₙ) est amplifié, puis à partir de là est formé le signal de sortie (Vₒᵤₜ) du capteur et le signal d'alarme est généré avec un niveau fixe, une fréquence fixe, ou analogues et est superposé au signal de sortie (Vₒᵤₜ) du capteur.

3. Procédé selon la revendication 2,
**caractérisé en ce que**
le niveau du signal d'alarme est sélectionné de telle sorte que le signal de sortie du capteur, en cas d'alarme, se situe hors de la zone de service normale du capteur.

4. Procédé selon l'une des revendications précédentes,
**caractérisé en ce que**
le signal de différence amplifié et le signal de pont complet (Vᵢₙ) ont, en outre, le même décalage et la même sensibilité, et sont traités en même temps avant l'étape de comparaison.

5. Utilisation du procédé selon l'une des revendications 1 à 4,
pour la surveillance du fonctionnement d'un capteur de pression, qui est utilisé pour mesurer la pression dans un système antiblocage ou lors d'un processus d'injection de diesel ou d'essence ou pour mesurer la pression dans des boîtiers de direction, des dispositifs de climatisation ou des boîtes de vitesses d'un véhicule.

6. Circuit pour la surveillance du fonctionnement d'un circuit de capteurs à pont symétrique (1), qui présente dans le circuit à pont complet des éléments de capteur (a, b, c, d) reliés les uns aux autres et alimentés par une tension d'alimentation de pont (Vₛ),
**caractérisé par**
- un amplificateur de différence (10) relié au circuit de capteurs à pont par des raccords de mesure, destiné à produire un signal de pont complet (Vᵢₙ) représentant le signal mesuré à partir de la différence entre le signal de demi-pont positif et négatif (Vᵢₙₚ-Vᵢₙₙ) ;
- un organe d'addition (2) relié au raccord de mesure positif ou négatif du circuit de capteurs à pont (1), destiné à soustraire le niveau momentané du signal de demi-pont positif ou négatif (Vᵢₙₚ ou Vᵢₙₙ) de la moitié de la tension d'alimentation de pont (Vₛ/2) et à générer un signal de différence correspondant (Vᵢₙₙ-Vₛ/2) ;
- un organe d'amplification (3) relié à l'organe d'addition (2), destiné à amplifier le signal de différence à l'aide d'un coefficient d'amplification donné (x), de telle sorte que le signal de différence, lors d'un fonctionnement correct du circuit de capteurs à pont, correspond au signal de pont complet (Vᵢₙ) ;
- un comparateur (5) relié à l'organe d'amplification (3), destiné à comparer le signal de pont complet (Vᵢₙ) avec le signal de différence amplifié, et
- un générateur de signal d'alarme (9) activé par le signal de sortie du comparateur (5), destiné à générer un signal d'alarme lorsque le signal de différence amplifié par l'organe d'amplification (3) est trop différent du signal de pont complet (Vᵢₙ).

7. Circuit selon la revendication 6,
**caractérisé en ce que**
le comparateur (5) présente un comparateur à cadran, dont le signal de sortie est le signal d'alarme qui, en tant que tension supplémentaire, est superposé par un signal de sortie (6) du capteur amplifié par un second organe d'amplification (12), de telle sorte que ce signal de sortie, en cas de défaillance du capteur, adopte une zone de signal hors de la zone de service normale du capteur.

8. Circuit selon la revendication 6 ou 7,
**caractérisé en ce qu'**
il est en outre prévu un dispositif de correction de la sensibilité et du décalage (4), qui soumet le signal de différence amplifié à l'aide du premier organe d'amplification (3) ainsi que le signal de pont complet (Vᵢₙ) à un traitement de décalage et de sensibilité dans les mêmes proportions et en même temps avant leur comparaison dans le comparateur (5).

9. Circuit selon l'une des revendications 6 à 8,
**caractérisé en ce que**
par le biais d'un générateur de tension à culot (7), une tension de culot (+_{culot}) est en outre superposée au signal de sortie du capteur et amène ce signal de sortie dans la zone de service du capteur.

10. Circuit selon l'une des revendications 6 à 9,
**caractérisé en ce qu'**
il est en outre prévu des moyens qui permettent de régler préalablement les degrés d'amplification de respectivement le premier et le deuxième organes d'amplification (3, 12), les tensions de référence du comparateur et du générateur de tension à culot (7) définissant la zone de service normale et la zone de signal d'alarme, conformément à la tension d'alimentation et aux caractéristiques du circuit de capteurs à pont complet (1) utilisé.

11. Utilisation du circuit selon l'une des revendications 6 à 10,
**caractérisée en ce que**
celui-ci est utilisé pour la surveillance du fonctionnement d'un capteur de pression utilisé pour mesurer la pression dans le système antiblocage d'un véhicule.

12. Utilisation du circuit selon l'une des revendications 6 à 10,
**caractérisée en ce que**
celui-ci est utilisé pour la surveillance du fonctionnement d'un capteur de pression utilisé pour mesurer la pression lors de l'injection de diesel ou de l'injection d'essence, dans un mécanisme de direction, dans un dispositif de climatisation ou dans une boîte de vitesses automatique.
